(19) **Europäisches Patentamt / European Patent Office / Office européen des brevets**

(11) **EP 4 694 657 A1**

(12) **EUROPEAN PATENT APPLICATION**
published in accordance with Art. 153(4) EPC

(43) Date of publication:
**11.02.2026 Bulletin 2026/07**

(21) Application number: **23930938.8**

(22) Date of filing: **19.12.2023**

(51) International Patent Classification (IPC):
*H10N 30/853* (2023.01)     *H10N 30/01* (2023.01)
*H10N 30/06* (2023.01)     *H10N 30/20* (2023.01)
*H10N 30/30* (2023.01)     *H10N 30/076* (2023.01)
*H10N 30/079* (2023.01)     *H10N 30/082* (2023.01)
*H10N 30/87* (2023.01)

(52) Cooperative Patent Classification (CPC):
**H10N 30/01; H10N 30/06; H10N 30/076;
H10N 30/079; H10N 30/082; H10N 30/20;
H10N 30/30; H10N 30/853; H10N 30/87**

(86) International application number:
**PCT/JP2023/045474**

(87) International publication number:
**WO 2024/202319 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **29.03.2023 JP 2023052800**

(71) Applicant: **Sumitomo Chemical Company, Limited
Tokyo 103-6020 (JP)**

(72) Inventors:
• **KURODA, Toshiaki**
  **Hitachi-shi, Ibaraki 319-1418 (JP)**
• **SHIBATA, Kenji**
  **Hitachi-shi, Ibaraki 319-1418 (JP)**
• **WATANABE, Kazutoshi**
  **Hitachi-shi, Ibaraki 319-1418 (JP)**

(74) Representative: **Vossius & Partner
Patentanwälte Rechtsanwälte mbB
Siebertstrasse 3
81675 München (DE)**

(54) **PIEZOELECTRIC MULTILAYER BODY, METHOD FOR PRODUCING PIEZOELECTRIC MULTILAYER BODY, AND PIEZOELECTRIC ELEMENT**

(57)    This disclosure involves a substrate, a bottom electrode film deposited on the substrate, and a piezoelectric film deposited on the bottom electrode film, the piezoelectric film being constituted by an alkali niobium oxide containing potassium, sodium, niobium and oxygen, wherein a piezoelectric constant $e_{31}$ of the piezoelectric film is 10 C/m$^2$ or more; when a negative voltage is applied to a top electrode film provided on the piezoelectric film, at a temperature of 200 °C in such a manner that an electric field of 300 kV/cm is generated between the bottom electrode film and the top electrode film, time from the start of the negative voltage application up to when the density of a leakage current flowing through the piezoelectric film exceeds 30 mA/cm$^2$ is 5 hours or more; and a film stress of the piezoelectric film is 150 MPa or less.

**FIG. 1**

**Description**

FIELD AND BACKGROUND OF THE INVENTION

The present disclosure relates to a piezoelectric stack, a method for manufacturing the piezoelectric stack, and a piezoelectric element.

Piezoelectric materials are widely used in functional electronic components such as sensors and actuators. A KNN-based ferroelectric containing potassium, sodium, niobium, and oxygen is used as the piezoelectric material, and a stack having a piezoelectric film (KNN film) deposited using such a piezoelectric material has been proposed. A KNN film is required to have a high piezoelectric constant and be less likely to undergo dielectric breakdown even when a large negative voltage is applied to the KNN film for a long time (that is, the KNN film has high DC stress withstand capability). There have been proposed a disclosure for achieving a higher piezoelectric constant of a KNN film (for example, see Patent Document 1) and a disclosure for enhancing DC stress withstand capability of a KNN film (for example, see Patent Documents 2 and 3).

PRIOR ART DOCUMENTS

PATENT DOCUMENTS

Patent Document 1: Japanese Patent Laid Open Publication No. 2009-295786
Patent Document 2: Japanese Patent Laid Open Publication No. 2017-076730
Patent Document 3: Japanese Patent Laid Open Publication No. 2018-207055

SUMMARY OF THE INVENTION

KNN films obtained in the above-described disclosures have a high piezoelectric constant or high DC stress withstand capability, but a film stress is high.

The present disclosure aims at providing a piezoelectric stack having a piezoelectric film, the piezoelectric film containing potassium, sodium, niobium and oxygen, and having a high piezoelectric constant, high DC stress withstand capability, and low film stress.

According to one aspect of the present disclosure, there are provided a piezoelectric stack and a piezoelectric element, each including:

a substrate;
a bottom electrode film deposited on the substrate; and
a piezoelectric film deposited on the bottom electrode film, the piezoelectric film being constituted by an alkali niobium oxide containing potassium, sodium, niobium and oxygen, wherein
a piezoelectric constant $e_{31}$ of the piezoelectric film is 10 C/m$^2$ or more,
when a negative voltage is applied to a top electrode film provided on the piezoelectric film, at a temperature of 200 °C in such a manner that an electric field of 300 kV/cm is generated between the bottom electrode film and the top electrode film, time from the start of the negative voltage application up to when the density of a leakage current flowing through the piezoelectric film exceeds 30 mA/cm$^2$ is 5 hours or more, and
a film stress of the piezoelectric film is 150 MPa or less.

According to another aspect of the present disclosure, there is provided a method for manufacturing a piezoelectric stack, the method including:

depositing a bottom electrode film on a substrate; and
depositing a piezoelectric film on the bottom electrode film, the piezoelectric film being constituted by an alkali niobium oxide containing potassium, sodium, niobium, and oxygen, wherein
in the deposition of the piezoelectric film, a first piezoelectric film as a part of the piezoelectric film is firstly deposited at a first temperature at which a (001) orientation ratio becomes 95 % or more and a film stress becomes 100 MPa or less, and then a second piezoelectric film as another part of the piezoelectric film is deposited at a second temperature at which a piezoelectric constant $e_{31}$ of the second piezoelectric film becomes 10 C/m$^2$ or more and at which when a negative voltage is applied to a top electrode film deposited on the second piezoelectric film in such a manner that an electric field of 300 kV/cm is generated between the bottom electrode film and the top electrode film, time up to when the density of a leakage current flowing through the second piezoelectric film exceeds 30 mA/cm$^2$ becomes 5 hours or more.

According to the present disclosure, a piezoelectric stack having a piezoelectric film can be provided, the piezoelectric film containing potassium, sodium, niobium and oxygen, and having a high piezoelectric constant, high DC stress withstand capability, and low film stress.

BRIEF DESCRIPTION OF THE DRAWINGS

[FIG. 1] FIG. 1 is a view illustrating one example of cross-sectional structure of a piezoelectric stack according to an aspect of the present disclosure.
[FIG. 2] FIG. 2 is a view illustrating one example of structure of a simple piezoelectric element according to an aspect of the present disclosure.
[FIG. 3] FIG. 3 is a view illustrating one example of schematic configuration of a piezoelectric element according to an aspect of the present disclosure.
[FIG. 4] FIG. 4 is a view illustrating one example of schematic configuration of a piezoelectric device module according to an aspect of the present disclosure.
[FIG. 5] FIG. 5(a) is a view illustrating one example of schematic configuration of a simple unimorph cantilever fabricated using each sample and FIG. 5(b) is a view explaining a method for measuring a piezoelectric constant.

DETAILED DESCRIPTION

<Findings Obtained by Inventors>

The present inventors have intensively studied to obtain a KNN film having both a high piezoelectric constant and high DC stress withstand capability. Consequently, the inventors have found that a KNN film having both a high piezoelectric constant and high DC stress withstand capability can be obtained by depositing a KNN film at a high temperature when depositing the KNN film on a substrate such as a silicon (Si) substrate by sputtering. However, while the KNN film can have the high piezoelectric constant and high DC stress withstand capability by depositing the KNN film at the high temperature, a film stress of the KNN film becomes high in this case. In a case where the temperature at the time of sputtering deposition is high, tensile stress in the film stress generated on the KNN film tends to become high. When a KNN film has a high film stress, for example, when a KNN film has a film stress of more than 150 MPa, large structural deformation occurs in fabricating a piezoelectric element with membrane structure, cantilever structure, or the like. Consequently, the fabricated piezoelectric element does not normally function. Manufacturing yields of piezoelectric elements and piezoelectric device modules also decrease. Therefore, a KNN film is required to have a low film stress, for example, a film stress of a KNN film is required to be 150 MPa or less.
The present inventors have intensively studied to obtain a KNN film including the following three features at the same time: "a piezoelectric constant is high", "DC stress withstand capability is high", and "a film stress is low". Such a KNN film had never been obtained before. Consequently, the present inventors have obtained the five findings listed below.
(The First Finding) A film stress of a KNN film obtained by sputtering deposition significantly depends on conditions in the early stage of depositing the KNN film.
(The Second Finding) Firstly (in the early stage of deposition) depositing a KNN film as a first layer (initial layer) under a temperature condition at which a film stress becomes low, and then depositing a KNN film as a second layer on the first layer under a temperature condition at which a piezoelectric constant and DC stress withstand capability become high ensures significant reduction in a film stress of the entire KNN film (stack of the first layer and second layer) even when the KNN film (the second layer) is deposited at a temperature that is so high that a high film stress is usually generated.
(The Third Finding) In order to obtain a KNN film having a high piezoelectric constant and high DC stress withstand capability with good reproducibility, a (001) orientation ratio of the KNN film needs to be high. In order to obtain a KNN film having a high (001) orientation ratio, a deposition temperature of the KNN film usually needs to be in a predetermined range. By depositing a KNN film as a first layer under a temperature condition at which a (001) orientation ratio becomes high in an early stage of deposition, and then depositing a KNN film as a second layer on the first layer under a temperature condition at which a piezoelectric constant and DC stress withstand capability become high, a KNN film having a high (001) orientation ratio can be obtained even when the KNN film (second layer) is deposited at a temperature that is so high that a (001) orientation ratio usually decreases. Note that, the (001) orientation ratio of the KNN film refers to an orientation ratio of crystals constituting the KNN film toward (001) direction, and will be described later in detail.
(The Fourth Finding) In order to obtain a KNN film having a high piezoelectric constant and high DC stress withstand capability with good reproducibility, a (001) orientation ratio of a KNN film needs to be 90 % or more. By depositing a KNN film as a first layer under a condition at which a (001) orientation ratio becomes 95 % or more in an early stage of deposition, a KNN film having a (001) orientation ratio of 90 % or more can be obtained even when a KNN film as a second layer is deposited after the first layer at a high temperature.

(The Fifth Finding) By depositing a KNN film as a first layer under a condition at which a film stress becomes low and a (001) orientation ratio becomes high in an early stage of deposition, and then depositing a KNN film as a second layer on the first layer under a temperature condition at which a piezoelectric constant and DC stress withstand capability become high, a KNN film having a high piezoelectric constant and high DC stress withstand capability can be obtained.

Based on the above five findings, the present inventors have found that a KNN film in which a piezoelectric constant and DC stress withstand capability are high and a film stress is 150 MPa or less can be obtained by depositing a KNN film as a first layer under a temperature condition at which a film stress becomes 100 MPa or less and a (001) orientation ratio becomes 95 % or more at an early stage of deposition, and then depositing a KNN film as a second layer under a temperature condition at which a piezoelectric constant and DC stress withstand capability of the KNN film become high.

The present disclosure has been made on the basis of the above-mentioned problems and findings obtained by the present inventors.

<Aspects of the Present Disclosure>

Hereinafter, aspects of the present disclosure will be explained with reference to drawings.

(1) Configuration of Piezoelectric Stack

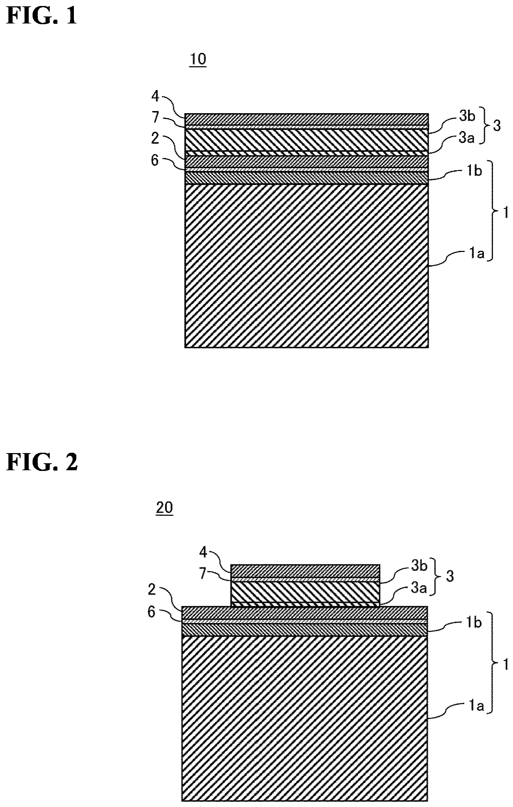

As illustrated in FIG. 1, a stack (stacked substrate) 10 having a piezoelectric film according to the present embodiment (hereinafter, also referred to as a piezoelectric stack 10) includes a substrate 1, a bottom electrode film 2 deposited on the substrate 1, a piezoelectric film (piezoelectric thin film) 3 deposited on the bottom electrode film 2, and a top electrode film 4 deposited on the piezoelectric film 3.

As the substrate 1, a single crystal silicon (Si) substrate 1a on which a surface oxide film ($SiO_2$ film) 1b such as a thermal oxide film or a chemical vapor deposition (CVD) oxide film is formed, in other words, a Si substrate having a surface oxide film may be suitably used. As the substrate 1, a Si substrate 1a having an insulating film may be used instead of the surface oxide film 1b, the insulating film being formed of an insulating material other than $SiO_2$. As the substrate 1, a Si substrate 1a in which a Si-(100), a Si-(111), or the like is exposed on a surface, that is, a Si substrate not having a surface oxide film 1b or an insulating film may also be used. As the substrate 1, a silicon on insulator (SOI) substrate or a quartz glass ($SiO_2$) substrate may also be used. The thickness of the single crystal Si substrate 1a may be, for example, 300 $\mu$m or more and 1000 $\mu$m or less, and the thickness of the surface oxide film 1b may be, for example, 1 nm or more and 4000 nm or less.

The bottom electrode film 2 may be formed using platinum (Pt), for example. The bottom electrode film 2 is a polycrystalline film. Hereinafter, a polycrystalline film deposited using Pt is also referred to as a Pt film. It is preferable that (111) of the Pt film is parallel to the main surface of the substrate 1 (this includes the case where the (111) is inclined at an angle within $\pm5°$ with respect to the main surface of the substrate 1), that is, the Pt film is oriented in (111) direction. The Pt film being oriented in the (111) direction means that peaks other than peaks caused by the (111) are not observed in an X-ray diffraction pattern obtained by X-ray diffraction (XRD) measured on a surface of the piezoelectric film 3. As above, the main surface of the bottom electrode film 2 (the surface that serves as the base of the piezoelectric film 3) is preferably constituted by Pt-(111). The bottom electrode film 2 may be deposited by a method such as sputtering or evaporation. The bottom electrode film 2 may be formed using materials such as, other than Pt, various metals including gold (Au), ruthenium (Ru), iridium (Ir), or the like, alloy containing these various metals as a main component, a metal oxide such as strontium ruthenium oxide ($SrRuO_3$, abbreviation: SRO) or lanthanum nickel oxide ($LaNiO_3$, abbreviation: LNO). Note that, in a case of depositing the bottom electrode film 2 by using metal oxide, the crystals constituting the bottom electrode film 2 are preferably oriented preferentially in the (001) direction with respect to a surface of the substrate 1. The bottom electrode film 2 may be a single-layer film formed using the above-described various metals, an alloy containing the above-described various metals as a main component, a metal oxide, or the like. The bottom electrode film 2 may be a stack of a Pt film and a film containing SRO as a main component and provided on the Pt film, a stack of a Pt film and a film containing LNO as a main component and provided on the Pt film, or the like. The thickness of the bottom electrode film 2 (in a case where the bottom electrode film 2 is a stack, the total thickness of all layers) may be 100 nm or more and 400 nm or less, for example.

An adhesion layer 6 may be provided between the substrate 1 and the bottom electrode film 2 in order to improve adhesion therebetween. The adhesion layer 6 may be a layer containing, for example, zinc (Zn) and oxygen (O) as main components (hereinafter, also referred to as a "ZnO layer"). The ZnO layer may be formed using, for example, zinc oxide. It is preferable that the composition ratio of Zn and O constituting the ZnO layer satisfies the relationship of Zn:O = 1:1 but the composition ratio is not limited thereto, and there may be some degree of variation. The ZnO layer is a polycrystalline layer. It is preferable that (0001) of the ZnO layer is parallel to the main surface of the substrate 1 (this includes the case where the (0001) is inclined at an angle within $\pm 5°$ with respect to the main surface of the substrate 1), that is, the ZnO layer is preferably oriented in the (0001) direction. The ZnO layer being oriented in the (0001) direction means that, in an X-ray diffraction pattern obtained by XRD measured on a surface of the piezoelectric film 3, peak intensity caused by

(0002) is high. As above, the main surface of the ZnO layer (the surface that serves as the base of the bottom electrode film 2) is preferably constituted by the ZnO-(0001). The ZnO layer may be deposited by a method such as sputtering or evaporation. The thickness of the ZnO layer may be, for example, 1 nm or more and 200 nm or less, preferably 10 nm or more and 50 nm or less. As the adhesion layer 6, a layer containing, for example, titanium (Ti), tantalum (Ta), titanium oxide ($TiO_2$), nickel (Ni), ruthenium oxide ($RuO_2$), iridium oxide ($IrO_2$), or the like as a main component may be provided. Such an adhesion layer 6 may also be deposited by a method such as sputtering or evaporation, and the thickness of the adhesion layer 6 may be, for example, 1 nm or more and 200 nm or less, preferably 10 nm or more and 50 nm or less. As used herein, the adhesion layer 6 provided between the substrate 1 and the bottom electrode film 2 may be referred to as a bottom adhesion layer 6.

The piezoelectric film 3 is a film formed from, for example, an alkali niobium oxide containing potassium (K), sodium (Na), niobium (Nb), and oxygen (O). That is, the piezoelectric film 3 is a film mainly composed of an alkali niobium oxide containing K, Na, Nb, and O. The piezoelectric film 3 may be formed using an alkali niobium oxide represented by a composition formula of $(K_{1-x}Na_x)NbO_3$, that is, potassium sodium niobate (KNN). The coefficient x [= Na/(K + Na)] in the above composition formula may be within a range of 0<x<1, preferably $0.4 \leq x \leq 0.8$. The piezoelectric film 3 is a polycrystalline film of KNN (hereinafter, also referred to as a KNN film 3). The crystal structure of KNN exhibits a perovskite structure. In other words, the KNN film 3 has a perovskite structure. In addition, it is preferable that half or more crystals of the crystal groups constituting the KNN film 3 have columnar structure. As used herein, the crystal system of KNN is regarded as a tetragonal system. The KNN film 3 may be deposited by sputtering. The thickness of the KNN film 3 may be, for example, 0.5 $\mu$m or more and 5$\mu$m or less, preferably 1 $\mu$m or more and 3 $\mu$m or less.

The crystals constituting the KNN film 3 are oriented preferentially in the (001) direction with respect to the main surface of the substrate 1 (when the substrate 1 is, for example, a Si substrate 1a having a surface oxide film 1b, an insulating film, or the like, then the Si substrate 1a). That is, the main surface of the KNN film 3 (the surface that serves as the base of the top electrode film 4) is mainly constituted by KNN-(001). The KNN film 3 having the main surface mainly constituted by KNN-(001) can be obtained by directly depositing the KNN film 3 on the Pt film (bottom electrode film 2) mainly constituted by Pt-(111), for example.

As used herein, crystals constituting the KNN film 3 being oriented in (001) direction means that (001) of the crystals constituting the KNN film 3 are parallel or substantially parallel to the main surface of the substrate 1. In addition, the crystals constituting the KNN film 3 being oriented preferentially in (001) direction means that (001) of many crystals are parallel or substantially parallel to the main surface of the substrate 1. For example, it is preferable that 90 % or more crystals of the crystal groups constituting the KNN film 3 are oriented in the (001) direction with respect to the main surface of the substrate 1. That is, it is preferable that an orientation ratio of the crystals constituting the KNN film 3 in the (001) direction (as used herein, also referred to as a "(001) orientation ratio") is 90 % or more for example, more preferably, 95 % or more. Note that, the term "(001) orientation ratio" as used herein is a value calculated using the following formula (1) on the basis of a peak intensity of an X-ray diffraction pattern (2θ/θ) obtained by carrying out XRD measurement on the KNN film 3.

$$\text{(001) orientation ratio (\%)} = \{\text{(001) peak intensity}/((001) \text{ peak intensity} + (110) \text{ peak intensity})\} \times 100 \qquad (1)$$

The term "(001) peak intensity" in the formula (1) is an intensity of a diffraction peak caused by a crystal oriented in (001) direction (that is, the crystal of which (001) being parallel to the main surface of the substrate 1) among crystals constituting the KNN film 3 in an X-ray diffraction pattern obtained by carrying out XRD measurement on the KNN film 3, and is an intensity of a peak appearing within a 2θ range of 20° to 23°. In a case where a plurality of peaks appear within the 2θ range of 20° to 23°, the (001) peak intensity is regarded as an intensity of the highest peak. In addition, the term "(110) peak intensity" in the formula (1) is an intensity of a diffraction peak caused by a crystal oriented in (110) direction (that is, the crystal of which (110) being parallel to the main surface of the substrate 1) among crystals constituting the KNN film 3 in an X-ray diffraction pattern obtained by carrying out XRD measurement on the KNN film 3, and is an intensity of a peak appearing within a 2θ range of 30° to 33°. In a case where a plurality of peaks appear within the 2θ range of 30° to 33°, the (110) peak intensity is regarded as an intensity of the highest peak.

The alkali niobium oxide constituting the KNN film 3 may further contain at least one element (dopant) selected from a group consisting of lithium (Li), magnesium (Mg), calcium (Ca), strontium (Sr), barium (Ba), bismuth (Bi), antimony (Sb), vanadium (V), indium (In), tantalum (Ta), molybdenum (Mo), tungsten (W), chromium (Cr), Ti, zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), Ni, aluminum (Al), Si, germanium (Ge), tin (Sn), and gallium (Ga). The concentration of the element in the alkali niobium oxide may be, for example, 5 atomic percent or less (in the case where more than one element mentioned above is contained, the total concentration of the elements may be 5 atomic percent or less).

As will be described later in detail, in the present embodiment, a first KNN film 3a (a first piezoelectric film, hereinafter, also referred to as "KNN film 3a") as a part of the KNN film 3 is firstly deposited at a first temperature at which a (001) orientation ratio becomes 95 % or more and a film stress becomes 100 MPa or less, and then a second KNN film 3b (a second piezoelectric film, hereinafter, also referred to as "KNN film 3b") as another part of the KNN film 3 is deposited on the KNN film 3a at a second temperature at which a piezoelectric constant and DC stress withstand capability become high. Accordingly, the KNN film 3 (that is, the stack of the KNN film 3a and the KNN film 3b) in the present embodiment includes all of features 1 to 3 to be described later at the same time. In addition, the KNN film 3 in the present embodiment may further include feature 4 to be described later.

Hereinafter, features 1 to 4 that the KNN film 3 of the present embodiment may include will be explained.

(Feature 1)

The KNN film 3 includes a feature in which "a piezoelectric constant $e_{31}$ is 10 C/m$^2$ or more". That is, the KNN film 3 includes a feature of having a high piezoelectric constant.

As used herein, the "piezoelectric constant $e_{31}$" is a value obtained at the time of measurement under a condition of applying a negative voltage (for example, voltage of a triangular wave or sinusoidal wave (sin wave)) to the top electrode film 4, in a state in which the bottom electrode film 2 is grounded, in such a manner that an electric field of 100 kV/cm is generated between the bottom electrode film 2 and the top electrode film 4 (that is, in the KNN film 3).

Since the KNN film 3 has the high piezoelectric constant, the later-described piezoelectric element 20 (piezoelectric device module 30) obtained by processing the piezoelectric stack 10 can exhibit higher performance. Consequently, the piezoelectric element 20 (piezoelectric device module 30) can be suitably applied to actuator applications.

The above feature can be expressed with good (and certain) reproducibility given that the (001) orientation ratio of the KNN film 3 (KNN film 3b) is 90 % or more.

(Feature 2)

The KNN film 3 includes a feature in which "when a highly accelerated life test (abbreviation: HALT) is conducted in which a negative voltage is applied to (the KNN film 3 through) the top electrode film 4 (in a state in which the bottom electrode film 2 is grounded), at a temperature of 200 °C (in a state in which the piezoelectric stack 10 is heated to a temperature of 200 °C), in such a manner that an electric field of 300 kV/cm is generated between the bottom electrode film 2 and the top electrode film 4 (that is, in the KNN film 3) (hereinafter, also referred to as "when conducting a HALT under the predetermined condition at a temperature of 200 °C"), time from the start of the negative voltage application up to when the density of a leakage current flowing through the KNN film 3 exceeds 30 mA/cm$^2$ is 5 hours or more". As above, the KNN film 3 includes a feature of exhibiting a long lifetime under DC stress, that is, having high DC stress withstand capability.

Since the KNN film 3 has high DC stress withstand capability, the KNN film 3 is less likely to undergo dielectric breakdown (time until when the KNN film 3 experiences dielectric breakdown is long) even when a high voltage (electric field) is applied to the KNN film 3 through the top electrode film 4 for a long time at the time of driving a later-described piezoelectric element 20 (piezoelectric device module 30) obtained by processing the piezoelectric stack 10 (hereinafter, also simply referred to as "at the time of driving"). Note that, it is regarded in the present embodiment that the KNN film 3 experiences dielectric breakdown at the point of time when the density of a leakage current flowing through the KNN film 3 exceeds 30 mA/cm$^2$.

This feature can be expressed with good (and certain) reproducibility given that the (001) orientation ratio of the KNN film 3 (KNN film 3b) is 90 % or more.

(Feature 3)

The KNN film 3 further includes a feature in which "a film stress is 150 MPa or less".

Since the KNN film 3 has the film stress of 150 MPa or less, occurrence of large structural deformation can be prevented when fabricating a piezoelectric element 20 having membrane structure, cantilever structure, or the like by processing a piezoelectric stack 10 in a manner described later. Accordingly, the later-described piezoelectric element 20 (later-described piezoelectric device module 30) obtained by processing the piezoelectric stack 10 can operate normally.

(Feature 4)

The KNN film 3 may further include a feature of "when an (alternating) negative voltage is continuously applied to (the KNN film 3 through) the top electrode film 4 in such a manner that a unipolar alternating electric field of 300 kV/cm is generated between the bottom electrode film 2 and the top electrode film 4 (that is, in the KNN film 3), the number of application cycles of the negative voltage until a piezoelectric displacement amount of the KNN film 3 decreases to 80 % or less of an initial piezoelectric displacement value is more than 10 million".

For example, in a case of using a piezoelectric stack 10 having a KNN film 3 with a thickness of 2 $\mu$m, when continuously applying an alternating voltage of a unipolar triangular wave or a unipolar sinusoidal wave (sin wave) with amplitude in the range of 0 V to -60 V to the KNN film 3 through the top electrode film 4 at a frequency of 300 Hz in a state in which the bottom electrode film 2 is grounded, the alternating voltage being applied in such a manner that the directions of the electric field applied to the KNN film 3 is not reversed (such that the directions of the electric field are aligned in one direction), the number of application cycles of the alternating voltage until a piezoelectric displacement amount of the KNN film 3 decreases to 80 % or less of an initial piezoelectric displacement value is more than 10 million.

The term "unipolar electric field" as used herein means an electric field directed at one direction even when the magnitude of voltage applied to the KNN film 3 through the top electrode film 4 periodically varies within a range from 0 V to -60 V, for example. In addition, as used herein, the phrase "the number of application cycles of a negative voltage until a piezoelectric displacement amount of the KNN film 3 decreases to 80 % or less of an initial piezoelectric displacement value when the negative voltage is continuously applied to the top electrode film 4 in such a manner that a unipolar alternating electric field of 300 kV/cm is generated in the KNN film 3" is also referred to as "the number of application cycles".

The KNN film 3 is deformed by applying an alternating voltage to the KNN film 3 through the top electrode film 4. As the applied voltage increases, the deformation of the KNN film 3 becomes larger. The KNN film 3 according to the present embodiment may include a feature in which the piezoelectric displacement amount is less likely to decrease, in other words, the KNN film 3 has excellent AC stress withstand capability, even when the KNN film 3 undergoes large deformation repeatedly by continuously being applied with a large alternating voltage.

In the piezoelectric stack 10 obtained by the above-mentioned novel method, the KNN film 3a having a high (001) orientation ratio and a low film stress, for example, the KNN film 3a having a (001) orientation ratio of 95 % or more and a film stress of 100 MPa or less is interposed between the bottom electrode film 2 and the KNN film 3b. Accordingly, the KNN film 3 (stack of the KNN film 3a and the KNN film 3b) according to the present embodiment can further have excellent AC stress withstand capability as compared with a case where the KNN film 3a is not interposed. This is considered to be because the presence of the interposed KNN film 3a can significantly improve the adhesion between the bottom electrode film 2 and the KNN film 3. The present inventors have found the following novel finding for the first time as a result of intensive studies: by interposing the KNN film 3a in the manner described above, the number of application cycles can be increased to more than 10 million, in other words, the AC stress withstand capability of the KNN film 3 can be enhanced.

Since the KNN film 3 has excellent AC stress withstand capability, the later-described piezoelectric element 20 (piezoelectric device module 30) obtained by processing the piezoelectric stack 10 can exhibit improved reliability.

The present inventors have confirmed that, in the piezoelectric stack 10 provided with a KNN film 3a having a (001) orientation ratio of 95 % or more and a film stress of 100 MPa or less interposed between the bottom electrode film 2 and the KNN film 3b, when a negative voltage is continuously applied to the KNN film 3 through the top electrode film 4 in such a manner that a unipolar alternating electric field of 300 kV/cm is generated in the KNN film 3, a piezoelectric displacement amount of the KNN film 3 can be maintained to 80 % or more of an initial piezoelectric displacement value after the number of application cycles reaches more than 10 million, or even 50 million or more.

On the contrary, in a case where the KNN film 3a is not interposed, that is, where the KNN film 3 is not constituted by a stack of the KNN film 3a and the KNN film 3b, in response to the KNN film 3 continuously undergoing large deformation by continuously being applied with a large alternating voltage through a top electrode film 4, the KNN film 3 peels off from the bottom electrode film 2 little by little. Consequently, the piezoelectric displacement amount of the KNN film 3 is likely to decrease.

The present inventors have confirmed that, in a piezoelectric stack provided with no KNN film 3a interposed between the bottom electrode film 2 and the KNN film 3b, when a negative voltage is continuously applied to the KNN film through the top electrode film 4 in such a manner that a unipolar alternating electric field of 300 kV/cm is generated in the KNN film, a piezoelectric displacement amount of a KNN film decreases to less than 80 % of an initial displacement value before the number of application cycles reaches 10 million.

As mentioned above, the KNN film 3 according to the present embodiment can include all of the features 1 to 3, preferably all of the features 1 to 4. Since the KNN film 3 includes all of the features 1 to 3, the later-described piezoelectric element 20 (piezoelectric device module 30) obtained by processing the piezoelectric stack 10 having the KNN film 3 can be suitably applied to actuator applications. In addition, since the KNN film 3 includes all of the features 1 to 4, the later-described piezoelectric element 20 (piezoelectric device module 30) can be more suitably applied to actuator applications.

In the present embodiment, when depositing the KNN film 3, the KNN film 3a is firstly deposited at a first temperature at which a (001) orientation ratio becomes 95 % or more and a film stress becomes 100 MPa or less, and then the KNN film 3b is deposited on the KNN film 3a at a second temperature at which a piezoelectric constant and DC stress withstand capability become high. Therefore, the KNN film 3 according to the present embodiment has stacked structure of the KNN film 3a as a first layer (initial layer) deposited at the first temperature and the KNN film 3b as a second layer deposited at the second temperature.

The KNN film 3a deposited at the first temperature has a low piezoelectric constant and low DC stress withstand capability. Therefore, when the ratio of a thickness of the KNN film 3a to the total thickness of the KNN film 3 (the total thickness of the KNN film 3a and the KNN film 3b) is increased, at least the feature 1 or feature 2 tends to be less likely expressed. Therefore, it is preferable that the thickness of the KNN film 3a is reduced to a minimum thickness necessary to reduce the film stress of the KNN film 3 and to reduce the film stress of the entire KNN film 3 to 150 MPa or less. The thickness of the KNN film 3a is not strictly limited. However, the thickness of the KNN film 3a is preferably 20 % or less of the total thickness of the KNN film 3, for example. Accordingly, the KNN film 3 including the features 1 and 2 (that is, the KNN film 3 having a high piezoelectric constant and high DC stress withstand capability) can certainly be obtained, preferably, the KNN film 3 including the features 1 and 2 can certainly be obtained with good reproducibility.

The top electrode film 4 contains as a main component, for example, various metals such as Pt, Au, Al, or Cu, or alloy containing the various metals. The top electrode film 4 may be deposited by a method such as sputtering, evaporation, plating, metal pasting, or the like. The top electrode film 4 does not significantly affect the crystal structure of the KNN film 3 unlike the bottom electrode film 2. Thus, materials, crystal structure, and deposition method of the top electrode film 4 are not particularly limited. An adhesion layer 7 may be provided between the KNN film 3 and the top electrode film 4 in order to improve the adhesion therebetween, the adhesion layer 7 containing, for example, $RuO_2$, $IrO_2$, Ti, Ta, $TiO_2$, or Ni as a main component. The thickness of the top electrode film 4 may be, for example, 50 nm or more and on 5000 nm or less, preferably 50 nm or more and 300 nm or less. In a case where the adhesion layer 7 is provided, the thickness of the adhesion layer 7 may be, for example, 1 nm or more and 200 nm or less, preferably 5 nm or more and 50 nm or less. As used herein, the adhesion layer 7 provided between the KNN film 3 and the top electrode film 4 may be referred to as a top adhesion layer 7.

(2) Method for Manufacturing Piezoelectric Stack, Piezoelectric Element, and Piezoelectric Device Module

A method for manufacturing the piezoelectric stack 10, the piezoelectric element, and the piezoelectric device module will be explained below.

(Deposition of Bottom Adhesion Layer and Bottom Electrode Film)

Firstly, a substrate 1 is prepared and a bottom adhesion layer 6 (for example, ZnO layer) and a bottom electrode film 2 (for example, Pt film) are deposited in this order on any main surface of the substrate 1 by sputtering, etc. Note that, a substrate 1 having any main surface on which a bottom adhesion layer 6 and a bottom electrode film 2 are deposited in advance may be prepared instead.

Conditions of depositing the ZnO layer as the bottom adhesion layer 6 are exemplified below. The deposition time of the bottom adhesion layer 6 is appropriately adjusted according to the target thickness of the bottom adhesion layer 6.

Target: ZnO sintered ceramics
Temperature (Substrate Temperature): 200 °C or more and 700 °C or less, preferably 300 °C or more and 700 °C or less, more preferably 500 °C or more and 700 °C or less
RF-Power Density: 2 $W/cm^2$ or more and 6 $W/cm^2$ or less, preferably 3 $W/cm^2$ or more and 5 $W/cm^2$ or less
Atmosphere: Atmosphere of mixed gas of argon (Ar) gas and oxygen ($O_2$) gas (hereinafter, also referred to as "Ar/$O_2$ mixed gas atmosphere")
Ratio of Partial Pressure of Ar Gas to $O_2$ Gas (Partial Pressure of Ar Gas/Partial Pressure of $O_2$ Gas): 5/1 to 30/1, preferably 7/1 to 20/1, and more preferably 10/1 to 15/1
Atmospheric Pressure: 0.1 Pa or more and 0.5 Pa or less, preferably 0.2 Pa or more and 0.4 Pa or less
Thickness: 1 nm or more and 200 nm or less, preferably 10 nm or more and 50 nm or less

As used herein, a numerical range such as "5/1 to 30/1" means that the lower limit value and the upper limit value are included in the range. The same applies to different numerical ranges.

Conditions of depositing a Ti layer or the like as the bottom adhesion layer 6 are exemplified below.

Target: Ti plate or the like
Temperature (Substrate Temperature): 100 °C or more and 500 °C or less, preferably 200 °C or more and 400 °C or less
Atmosphere: Ar gas atmosphere

Atmospheric Pressure: 0.1 Pa or more and 0.5 Pa or less, preferably 0.2 Pa or more and 0.4 Pa or less

The other conditions may be similar to the conditions of providing the ZnO layer.

Conditions of depositing a Pt film as the bottom electrode film 2 are exemplified below. The deposition time of the bottom electrode film 2 is appropriately adjusted according to the target thickness of the bottom electrode film 2.

Target: Pt plate
Temperature (Substrate Temperature): 200 °C or more and 600 °C or less, preferably 300 °C or more and 500 °C or less
RF-Power Density: 1 $W/cm^2$ or more and 5 $W/cm^2$ or less, preferably 2 $W/cm^2$ or more and 4 $W/cm^2$ or less
Atmosphere: Ar gas atmosphere
Atmospheric Pressure: 0.1 Pa or more and 0.5 Pa or less, preferably 0.2 Pa or more and 0.4 Pa or less
Thickness: 100 nm or more and 400 nm or less

(Deposition of KNN film)

After the deposition of the bottom adhesion layer 6 and the bottom electrode film 2, a KNN film 3 is next deposited on the bottom electrode film 2 by sputtering such as RF magnetron sputtering. The composition of the KNN film 3 can be adjusted by, for example, controlling composition of a target used at the time of sputtering deposition. The target can be fabricated by mixing $K_2CO_3$ powder, $Na_2CO_3$ powder, $Nb_2O_5$ powder, and the like and firing the mixture, for example. The composition of the target can be controlled by adjusting mixing ratio of $K_2CO_3$ powder, $Na_2CO_3$ powder, $Nb_2O_5$ powder, and the like. In a case of depositing a KNN film 3 containing the above-mentioned elements such as Cu or Mn, a target fabricated by mixing Cu powder (or CuO powder), Mn powder (or MnO powder), or the like at a predetermined ratio in addition to the above-mentioned powders may be used.

The deposition of the KNN film 3 is performed in two stages while changing temperature conditions. Specifically, firstly (in the early stage of deposition), the KNN film 3a is deposited at a first temperature and then the KNN film 3b is deposited at a second temperature.

The first temperature is a temperature at which a (001) orientation ratio of the KNN film 3a becomes 95 % or more and a film stress of the KNN film 3a becomes 100 MPa or less. For example, the first temperature is a temperature at which the (001) orientation ratio of the KNN film 3a becomes 95 % or more when the KNN film 3a with a thickness of 2 $\mu m$ ($\pm 10$ %) is deposited at the first temperature. In addition, the first temperature is a temperature at which the film stress of the KNN film 3a becomes 100 MPa or less when the KNN film 3a with a thickness of 2 $\mu m$ ($\pm 10$ %) is deposited at the first temperature, for example.

The second temperature is a temperature at which the piezoelectric constant $e_{31}$ of the KNN film 3b becomes 10 $C/m^2$ or more. In addition, the second temperature is a temperature at which, when conducting a HALT under the predetermined condition at a temperature of 200 °C, time from the start of the voltage application up to when the density of a leakage current flowing through the KNN film 3b exceeds 30 $mA/cm^2$ becomes 5 hours or more.

While the first temperature and the second temperature may more or less depend on a sputtering deposition apparatus and deposition conditions, in the sputtering deposition of the KNN film 3 in the present embodiment, the second temperature is usually higher than the first temperature (first temperature < second temperature). For example, the first temperature may be within a range of 550 °C or more and 600 °C or less, and the second temperature may be within a range of 650 °C or more and 800 °C or less.

Conditions of depositing the KNN film 3 (KNN film 3a and KNN film 3b) other than the temperature are exemplified below for the deposition at both of the first temperature and the second temperature.

RF-Power Density: 2.7 $W/cm^2$ or more and 4.1 $W/cm^2$ or less, preferably 2.8 $W/cm^2$ or more and 3.8 $W/cm^2$ or less
Atmosphere: atmosphere containing at least Ar gas, preferably $Ar/O_2$ mixed gas atmosphere
Atmospheric Pressure: 0.03 Pa or more and 0.5 Pa or less, preferably 0.04 Pa or more and 0.4 Pa or less
Ratio of Partial Pressure of $O_2$ Gas to Ar Gas (Partial Pressure of $O_2$ Gas/Partial Pressure of Ar Gas): 0 to 1/20, preferably 0 to 1/30
Deposition Rate: 0.5 $\mu m/hr$ or more and 4 $\mu m/hr$ or less, preferably 0.5 $\mu m/hr$ or more and 2 $\mu m/hr$ or less
Total Thickness of KNN Film: 0.5 $\mu m$ or more and 5 $\mu m$ or less, preferably 1 $\mu m$ or more and 3 $\mu m$ or less

Note that, the phrase "partial pressure of $O_2$ gas/partial pressure of Ar gas: 0 (zero)" means a case where the partial pressure of $O_2$ gas is 0, that is, the atmosphere consists only of Ar gas. The term "total thickness of the KNN film" refers to the total thickness of the KNN film 3a deposited at the first temperature and the KNN film 3b deposited at the second temperature. The deposition time of the KNN film 3a and the KNN film 3b are appropriately adjusted according to the target thickness of the KNN films 3a and 3b. As mentioned above, it is preferable that the thickness of the KNN film 3a is a minimum thickness necessary to reduce the film stress in the KNN film 3b in the deposition at the second temperature and to reduce the film stress of the entire KNN film 3 to 150 MPa or less. Therefore, the deposition time (deposition time at the first temperature) of the KNN film 3a is preferably adjusted in such a manner that the thickness of the KNN film 3a becomes 20 % or less of the total thickness of the KNN film 3, for example.

Firstly depositing the KNN film 3a at the first temperature at which the (001) orientation ratio becomes 95 % or more and the film stress becomes 100 MPa or less, and then depositing the KNN film 3b on the KNN film 3a at the second temperature at which the piezoelectric constant and DC stress withstand capability become high in the manner mentioned above ensures significant reduction in the film stress of the entire KNN film 3 after the deposition of the KNN film 3b even when the second temperature is so high that a high film stress is generated on the KNN film 3b. Consequently, the KNN film 3 having the high piezoelectric constant, the high DC stress withstand capability, and the low film stress can be obtained. In other words, the KNN film 3 including all of the features 1 to 3 can be obtained by depositing the KNN film 3 (KNN film 3a and KNN film 3b) in two stages while changing temperature under the above-mentioned conditions. Further, the KNN film 3 including all of the features 1 to 4 can be obtained by depositing the KNN film 3 in two stages while changing temperature under the above-mentioned conditions, in other words, by providing the KNN film 3a having a high (001) orientation ratio and a low film stress.

(Deposition of Top Adhesion Layer and Top Electrode Film)

After the deposition of the KNN film 3, a top adhesion layer 7 (for example, $RuO_2$ layer) and a top electrode film 4 (for example, Pt film) are deposited on the KNN film 3 in this order by sputtering, for example.

Conditions of depositing the $RuO_2$ layer or the like as the top adhesion layer 7 are exemplified below. The deposition time of the top adhesion layer 7 is appropriately adjusted according to the target thickness of the top adhesion layer 7.

Target: Ru plate or the like
Temperature (Substrate Temperature): Room temperature (25 °C) or more and 500 °C or less
RF-Power Density: 0.3 $W/cm^2$ or more and 2 $W/cm^2$ or less, preferably 0.5 $W/cm^2$ or more and 1 $W/cm^2$ or less
Atmosphere: $Ar/O_2$ mixed gas atmosphere
Ratio of Partial Pressure of Ar Gas to $O_2$ Gas (Partial Pressure of Ar Gas/Partial Pressure of $O_2$ Gas): 3/5 to 1/1, preferably 3/4 to 1/1
Atmospheric Pressure: 0.1 Pa or more and 1.0 Pa or less, preferably 0.2 Pa or more and 0.7 Pa or less
Thickness: 1 nm or more and 200 nm or less, preferably 5 nm or more and 50 nm or less

Conditions of depositing a Pt film or the like as the top electrode film 4 are exemplified below. The deposition time of the top electrode film 4 is appropriately adjusted according to the target thickness of the top electrode film 4.

Target: Pt plate or the like
Temperature (Substrate Temperature): Room temperature (25 °C) or more and 500 °C or less
RF-Power Density: 1 $W/cm^2$ or more and 5 $W/cm^2$ or less, preferably 2 $W/cm^2$ or more and 4 $W/cm^2$ or less
Atmosphere: Ar gas atmosphere
Atmospheric Pressure: 0.1 Pa or more and 0.5 Pa or less, preferably 0.2 Pa or more and 0.4 Pa or less
Thickness: 50 nm or more and 5000 nm or less, preferably 50 nm or more and 300 nm or less

By depositing the bottom adhesion layer 6, the bottom electrode film 2, the KNN film 3 (KNN films 3a and 3b), the top adhesion layer 7, and the top electrode film 4 in this order in the manner mentioned above, such a piezoelectric stack 10 as illustrated in FIG. 1 can be obtained.

(Fabrication of Piezoelectric Element)

After fabricating such a piezoelectric stack 10 as illustrated in FIG. 1, the piezoelectric stack 10 is processed into an element (also referred to as piezoelectric element 20) having the KNN film 3.

Specifically, firstly, the top electrode film 4 (also including the top adhesion layer 7) and the KNN film 3 are individually patterned by dry etching using, for example, Ar gas or reactive gas. In the patterning, the top electrode film 4 (also including the top adhesion layer 7) and the KNN film 3 are formed into predetermined shapes, and a part of the bottom electrode film 2 is exposed. In the patterning, a photoresist may be used as an etching mask. FIG. 2 illustrates the piezoelectric stack 10 after completion of the patterning, that is, a piezoelectric element 20. The piezoelectric element 20 illustrated in FIG. 2 is also referred to as a simple piezoelectric element.

After fabrication of such a simple piezoelectric element as illustrated in FIG. 2, the bottom electrode film 2 and the bottom adhesion layer 6 are patterned by dry etching using, for example, Ar gas or reactive gas, and the bottom electrode film 2 and the bottom adhesion layer 6 are formed into predetermined shapes. In this patterning, a photoresist may be used as an etching mask.

After the patterning of the bottom electrode film 2 and the bottom adhesion layer 6, the insulating film 8 and metal wirings 9a and 9b are provided. Specifically, firstly, a layer composed of an insulating material is provided from the top electrode film 4 to the substrate 1 so as to cover the side surface of the KNN film 3, and the insulating film 8 is provided by patterning the layer composed of the insulating material by dry etching using reactive gas such as Ar gas or $CF_4$ gas, or by wet etching. The insulating film 8 may be formed using an oxide such as silicon oxide ($SiO_2$), aluminum oxide ($Al_2O_3$), or tantalum oxide ($Ta_2O_5$), or the like. The insulating film 8 may be a single-layer film, or a stack in which a plurality of layers are stacked. The insulating film 8 may be provided by a method such as CVD or sputtering.

After provision of the insulating film 8, a layer composed of a material containing metal (metal wiring layer) is provided. Then, the metal wiring layer is patterned by dry etching using Ar gas or reactive gas, or by wet etching, thereby forming the metal wirings 9a and 9b. The metal wiring 9a is formed (patterned) so as to be connected to (in contact with) the bottom electrode film 2 and not connected to (not in contact with) the top electrode film 4, and the metal wiring 9b is formed so as to be connected to the top electrode film 4 and not connected to the bottom electrode film 2. The metal wirings 9a and 9b may be formed using various metals such as Au, Al, Ti, or Cr, or alloy containing the various metals as a main component. The metal wirings 9a and 9b may be single-layer films, or stack in which a plurality of layers are stacked. The metal wirings 9a and 9b (metal wiring layers) may be provided by a method such as sputtering, evaporation, plating, metal pasting, or the like.

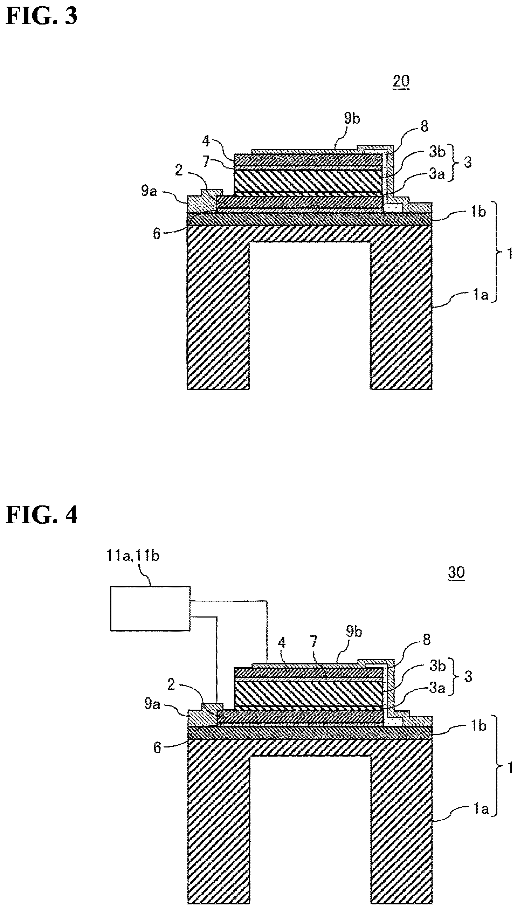

A part of the substrate 1 is removed from a back surface of the substrate 1 (one of the two main surfaces of the substrate 1, the surface opposite to the surface on which the bottom electrode film 2 and the like are deposited) by Deep-RIE or wet etching. Accordingly, a piezoelectric element 20 having membrane structure, cantilever structure, or the like, for example, such a membrane MEMS piezoelectric element 20 as illustrated in FIG. 3 can be obtained.

Etching conditions in patterning at the time of forming the insulating film 8 and the metal wirings 9a and 9b and etching conditions of the substrate 1 when processing the piezoelectric stack 10 into the piezoelectric element 20 may be general etching conditions used in a semiconductor device manufacturing process as long as the insulating properties of the KNN film 3 are not degraded.

(Fabrication of Piezoelectric Device Module)

By connecting a voltage applicator 11a to the obtained piezoelectric element 20, a device module 30 (hereinafter, also referred to as a piezoelectric device module 30) having the KNN film 3 can be obtained. FIG. 4 is a view illustrating schematic configuration of the piezoelectric device module 30 according to the present embodiment. The piezoelectric device module 30 at least includes the piezoelectric element 20 and the voltage applicator 11a connected to the piezoelectric element 20. The voltage applicator 11a is a means that applies a voltage between the bottom electrode film 2 and the top electrode film 4 (between the electrodes). Various known means can be used as the voltage applicator 11a.

By connecting the voltage applicator 11a between the bottom electrode film 2 and the top electrode film 4 of the piezoelectric element 20, the piezoelectric device module 30 can function as an actuator. The KNN film 3 can be deformed by applying voltage between the bottom electrode film 2 and the top electrode film 4 by voltage applicator 11a. This deformation operation enables operation of the various structures connected to the piezoelectric element 20. In this case, examples of applications of the piezoelectric element 20 include a head for an inkjet printer, a MEMS mirror for an optical scanner, and a vibrator for an ultrasonic wave generating apparatus.

(3) Effects

According to the present embodiment, one or more of the following effects can be obtained.

(a) The KNN film 3 includes all of the following features at the same time: the piezoelectric constant $e_{31}$ is 10 C/m$^2$ or more (the feature 1), when conducting a HALT under the predetermined condition at a temperature of 200 °C, time from the start of voltage application up to when the density of a leakage current flowing through the KNN film 3 exceeds 30 mA/cm$^2$ is 5 hours or more (the feature 2), and a film stress is 150 MPa or less (the feature 3). That is, the KNN film 3 has the high piezoelectric constant, the high DC stress withstand capability, and the low film stress.

Since the piezoelectric constant $e_{31}$ of the KNN film 3 is 10 C/m$^2$ or more, the piezoelectric property of the KNN film 3 can be enhanced. Further, since the KNN film 3 has high DC stress withstand capability, the KNN film 3 is less likely to undergo dielectric breakdown even when a high voltage is applied to the KNN film 3 through the top electrode film 4 for a long time at the time of driving the piezoelectric element 20 (piezoelectric device module 30). Accordingly, the piezoelectric element 20 (piezoelectric device module 30) can be suitably applied to actuator applications.

Since the film stress of the KNN film 3 is 150 MPa or less, occurrence of large structural deformation can be prevented when fabricating the piezoelectric element 20 (piezoelectric device module 30) having membrane structure, cantilever structure, or the like by processing the piezoelectric stack 10. Accordingly, the piezoelectric element 20 (piezoelectric device module 30) obtained by processing the piezoelectric stack 10 can operate normally. For example, the piezoelectric element 20 (piezoelectric device module 30) can certainly function as an actuator.

As described above, since the KNN film 3 includes all of the features 1 to 3, the piezoelectric element 20 (piezoelectric device module 30) obtained by processing the piezoelectric stack 10 can be suitably applied to actuator applications.

(b) Since there is interposed the KNN film 3a having a high (001) orientation ratio and a low film stress between the bottom electrode film 2 and the KNN film 3b, the KNN film 3 may further include a feature in which the above-mentioned the number of application cycles is more than 10 million (the feature 4) in addition to the features 1 to 3. That is, the KNN film 3 may have a high piezoelectric constant, high DC stress withstand capability, low film stress, and excellent AC stress withstand capability.

Since the KNN film 3 has excellent AC stress withstand capability, in other words, the piezoelectric displacement amount of the KNN film 3 is less likely to decrease even when the KNN film 3 undergoes large deformation repeatedly, reliability of the piezoelectric element 20 (piezoelectric device module 30) can be improved.

As described above, since the KNN film 3 includes all of the features 1 to 4, the piezoelectric element 20 (piezoelectric device module 30) obtained by processing the piezoelectric stack 10 can be more suitably applied to actuator applications.

(c) The KNN film 3 including all of the features 1 to 3, preferably all of the features 1 to 4 can be obtained, when depositing the KNN film 3, by firstly depositing the KNN film 3a at a first temperature at which a (001) orientation ratio becomes 95 % or more and a film stress becomes 100 MPa or less, and then depositing a KNN film 3b on the KNN film 3a at a second temperature at which a piezoelectric constant and DC stress withstand capability become high.

(4) Modification Example

The present disclosure is not limited to the above-described embodiments and can be modified in the manner described below, for example.

(Modification Example 1)

The KNN film 3 may be annealed after the deposition of the KNN film 3, preferably after the deposition of the KNN film 3 and before the deposition of the top electrode film 4 (top adhesion layer 7). In the present modification example, effects similar to the effects of the above-described embodiments can be obtained. In addition, in the present modification example, DC stress withstand capability can be further enhanced. In other words, when conducting a HALT under the predetermined condition at a temperature of 200 °C, time from the start of the voltage application up to when the density of a leakage current flowing through the KNN film 3 exceeds 30 mA/cm$^2$ can be made even longer. Moreover, the piezoelectric constant $e_{31}$ of the KNN film 3 can certainly be increased.

Conditions for annealing are exemplified below.

Atmosphere: Oxygen-containing atmosphere such as ambient air
Temperature: 500 °C or more and 700 °C or less, preferably 550 °C or more and 650 °C or less
Time: 10 minutes or more and 5 hours or less, preferably 30 minutes or more and 3 hours or less

<Other Aspects>

Aspects of the present disclosure have been specifically explained above. However, the present disclosure is not limited to the above-described aspects, and various modifications can be made without departing from the scope of the present disclosure. Any of those aspects can be combined.

In the above-described aspect, the example in which the piezoelectric device module 30 functions as an actuator has been explained, but the present disclosure is not limited thereto. That is, the piezoelectric device module 30 may function as a sensor instead. In this case, the piezoelectric device module 30 at least includes a piezoelectric element 20 obtained by forming the piezoelectric stack 10 into a predetermined shape and a voltage detector 11b (see FIG. 4) connected to the piezoelectric element 20. The voltage detector 11b is a means that detects a voltage generated between the bottom electrode film 2 and the top electrode film 4 (between the electrodes). Various known means can be used as the voltage detector 11b. Since the voltage detector 11b is connected between the bottom electrode film 2 and the top electrode film 4 of the piezoelectric element 20, the piezoelectric device module 30 can function as a sensor. When the KNN film 3 is deformed due to a change in some physical quantity, a voltage is generated between the bottom electrode film 2 and the top electrode film 4 by the deformation. By detecting this voltage by the voltage detector 11b, the magnitude of the physical quantity applied to the KNN film 3 can be measured. In this case, examples of applications of the piezoelectric device module 30 include an angular velocity sensor, an ultrasonic sensor, a pressure sensor, and an acceleration sensor.

For example, when the above-mentioned piezoelectric stack 10 is formed into the piezoelectric element 20, the substrate 1 included in the piezoelectric stack 10 may be bonded to another substrate as long as the piezoelectric device module 30 fabricated using the piezoelectric stack 10 (piezoelectric element 20) can be applied to a desired application such as an actuator application.

[Examples]

Hereinafter, experimental results that support the effects of the above-described embodiments will be explained.

[Experiment 1]

Experiments were performed to confirm temperatures applicable as the first temperature and the second temperature when depositing the KNN film.

(Fabrication of Samples A to J)

As a substrate, a Si substrate having a surface of (100) direction, a thickness of 610 $\mu$m, a diameter of 6 inches (also referred to as "$\phi$6 inches"), and a thermal oxide film (thickness: 200 nm) formed on the surface was prepared. Then, each of Samples A to J was fabricated as a piezoelectric stack by depositing a ZnO layer (thickness: 25 nm) as a bottom adhesion layer, a Pt film (preferentially oriented in (111) direction with respect to the surface of the substrate, thickness: 200 nm) as a bottom electrode film, a KNN film (thickness: 2 $\mu$m) as a piezoelectric film, a $RuO_2$ layer (thickness: 10 nm) as a top adhesion layer, and a Pt film (thickness: 100 nm) as a top electrode film in this order on the thermal oxide film of the Si substrate. In Samples A to J, the bottom adhesion layers, the bottom electrode films, the KNN films, the top adhesion layers, and the top electrode films were all deposited by RF magnetron sputtering.

Conditions of depositing the ZnO layer as the bottom adhesion layer are as follows.

Target: ZnO sintered ceramics
Substrate Temperature: 500 °C
RF-Power Density: 4 W/cm$^2$
Atmosphere: Ar/O$_2$ mixed gas atmosphere
Atmospheric Pressure: 0.3 Pa
Partial Pressure of Ar Gas/Partial Pressure of O$_2$ Gas: 10/1
Deposition Time: 3 minutes (thickness: 25 nm)

Conditions of depositing the Pt film as the bottom electrode film are as follows.

Target: Pt plate
Substrate Temperature: 500 °C
RF-Power Density: 2 W/cm$^2$
Atmosphere: Ar gas atmosphere
Atmospheric Pressure: 0.3 Pa
Deposition Time: 14 minutes (thickness: 200 nm)

Conditions of depositing the KNN film are as follows.

Target: KNN sintered ceramics
RF-Power Density: 3 W/cm$^2$
Atmosphere: Ar/O$_2$ mixed gas atmosphere
Atmospheric Pressure: 0.1 Pa
Partial Pressure of O$_2$ Gas/Partial Pressure of Ar Gas: 1/20
Deposition Temperature: A predetermined temperature within a range of 300 °C or more and 800 °C or less

Deposition Time: 60 minutes (thickness: 2000 nm (2 $\mu$m))

Conditions of depositing the RuO$_2$ layer as the top adhesion layer are as follows.

Target: Ru plate
Substrate Temperature: Room temperature (25 °C)
RF-Power Density: 0.5 W/cm$^2$
Atmosphere: Ar/O$_2$ mixed gas atmosphere
Atmospheric Pressure: 0.3 Pa
Partial Pressure of Ar Gas/Partial Pressure of O$_2$ Gas: 1/1
Deposition Time: 6 minutes (thickness: 10 nm)

Conditions of depositing the Pt film as the top electrode film are as follows.

Target: Pt plate
Substrate Temperature: Room temperature (25 °C)
RF-Power Density: 2 W/cm$^2$
Atmosphere: Ar gas atmosphere
Atmospheric Pressure: 0.3 Pa
Deposition Time: 7 minutes (thickness: 100 nm)

Samples A to J were fabricated under conditions the same as the conditions described above except for the deposition temperatures of the KNN films. The deposition temperatures of the KNN films of Samples A to J are shown in Table 1 below.

<Evaluations>

For each of Samples A to J, a (001) orientation ratio, film stress, DC stress withstand capability, and piezoelectric constant $e_{31}$ of the KNN film were evaluated.

(Evaluations on (001) Orientation Ratios)

The (001) orientation ratio of the KNN film was evaluated by calculating the (001) orientation ratio using the above formula (1) on the basis of peak intensity of an X-ray diffraction pattern ($2\theta/\theta$) obtained by carrying out XRD measurement on the KNN film. The XRD measurement was carried out after the deposition of the KNN film and before the deposition of the top adhesion layer and the top electrode film. Calculation results for (001) orientation ratios are shown in Table 1 below. Note that, the term "Orientation Ratio" in Table 1 means a (001) orientation ratio of the KNN film.

(Evaluations on Film Stress)

Stress of a thin film on a substrate can be calculated by measuring the amount of warpage of the substrate caused due to the thin film, specifically, a radius of curvature of the warpage of the substrate, as in the following formula (2). Therefore, in the present evaluation, firstly, the radius of curvature R of the warpage of the substrate (Si substrate) of each sample was measured after the bottom adhesion layer, bottom electrode film, and KNN film were deposited and before the top adhesion layer and top electrode film were deposited. Then, film stress of the KNN film of each sample was calculated using the following formula (2). In the present evaluation, the radius of curvature R of the Si substrate was calculated from a warped shape of the Si substrate after the bottom adhesion layer, the bottom electrode film, and the KNN film were deposited, the warped shape being measured by a laser displacement meter.

$$\sigma = \left( \frac{E_s}{1 - \nu_s} \right) \frac{h^2}{6 \, R \, t} \cdot \cdot \cdot (2)$$

In formula (2), σ is stress of a thin film (KNN film), $E_s/(1-\nu_s)$ is a biaxial elastic modulus (Pa) of a substrate, h is a thickness (m) of the substrate, R is a radius of curvature (m) of warpage of the substrate, and t is a thickness (m) of the KNN film. In Samples A to J, since the Si substrate was used as the substrate, the value of the biaxial elastic modulus was set to 30.3. Also, a film stress (σ) of the KNN film was calculated on the assumption that the Si substrate was sufficiently flat. While the bottom adhesion layer (ZnO layer) and the bottom electrode film (Pt film) are deposited in each of Samples A to J, the thickness of the bottom adhesion layer (25 nm) and the thickness of the bottom electrode film (200 nm) are sufficiently thinner as compared with the thickness of the KNN film (2 μm). Therefore, the influence of the bottom adhesion layer and the bottom electrode film was ignored in the calculation of the film stress of the KNN film.

Calculation results of the film stress of the KNN films of Samples A to J are shown in Table 1 below. In Table 1, the term "Compressive" means that the film stress is compressive stress and the term "Tensile" means that the film stress is tensile stress.

(Evaluations on Piezoelectric Constant $e_{31}$)

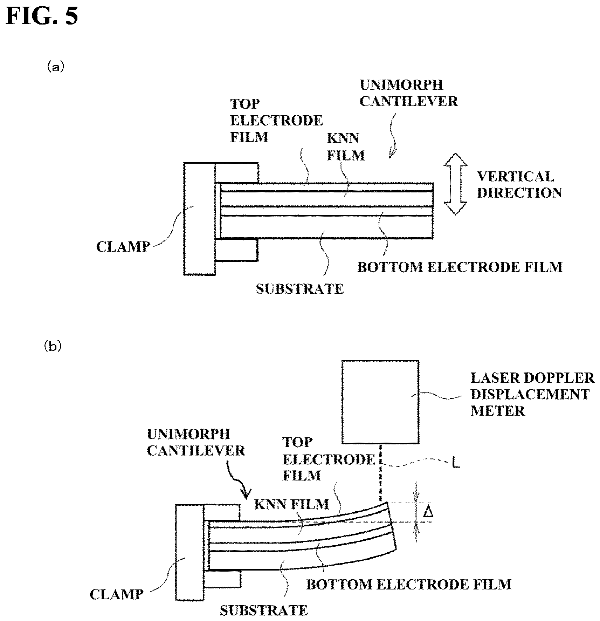

The piezoelectric constant $e_{31}$ of the KNN film was calculated in the manner described below. Firstly, strip-shaped pieces each having a length of 20 mm and a width of 2.5 mm were cut out from each of Samples A to J. Next, as illustrated in FIG. 5(a), a simple unimorph cantilever was fabricated by fixing one end in a longitudinal direction of the piece obtained from each of Samples A to J by a clamp, and connecting a voltage applicator (not illustrated) between the bottom electrode film and the top electrode film. Then, by using the voltage applicator, the KNN film was expanded and contracted (deformed) by applying a negative sin wave voltage to the KNN film through the top electrode film in such a manner that an electric field of 100 kV/cm was generated between the bottom electrode film and the top electrode film (that is, in the KNN film) in a state in which the bottom electrode film was grounded. The deformation operation of the KNN film causes the entire cantilever to bend and stretch (vibrate) and a tip of the cantilever to reciprocate in a vertical direction. A displacement amount Δ of the tip of the cantilever (piezoelectric displacement amount) at this moment was measured by irradiating the tip of the cantilever with a laser beam L from a laser Doppler displacement meter as illustrated in FIG. 5(b). Finally, the piezoelectric constant $e_{31}$ at the time of when the applied electric field was 100 kV/cm was calculated using the displacement amount Δ of the tip of the cantilever, the length of the cantilever, and the applied voltage. The measurement results of the piezoelectric constants $e_{31}$ are shown in Table 1.

In FIGS. 5(a) and 5(b), for the sake of clarity, illustration of the bottom adhesion layer and the top adhesion layer is omitted. Meanwhile, in a case where a KNN film is a stack of a first KNN film and a second KNN film, this stack is illustrated as the KNN film.

(Evaluations on DC Stress Withstand Capability)

DC stress withstand capability was evaluated by measuring a DC stress lifetime. Specifically, the DC stress lifetime was evaluated by measuring, when conducting a HALT in which a negative voltage is applied to (the KNN film through) the top electrode film at a temperature of 200 °C in such a manner that an electric field of 300 kV/cm is generated in the KNN film, time from the start of the negative voltage application up to when the density of a leakage current flowing through the KNN film exceeds 30 mA/cm[2]. Note that, in the HALT, a predetermined negative voltage was applied to the top electrode film while the bottom electrode film was grounded. The measurement results are shown in Table 1 below.

[Table 1]

| Sample | Deposition Temperature (°C) | Orientation Ratio (%) | Film Stress (MPa) (*6) | Piezoelectric Constant $e_{31}$ (C/m[2]) | DC Stress Lifetime (hr) | Assessment |
|---|---|---|---|---|---|---|
| A | 300 | (*1) | 200 (C) | (*1) | 1 | (*2) |
| B | 400 | 90 | 250 (C) | 4 | 1 | (*3) |
| C | 450 | 95 | 230 (C) | 6 | 2 | (*3) |
| D | 500 | 100 | 200 (C) | 7 | 2 | (*3) |
| E | 550 | 100 | 50 (C) | 7 | 3 | (*4) |
| F | 600 | 95 | 100 (T) | 8 | 3 | (*4) |
| G | 650 | 90 | 200 (T) | 10 | 5 | (*5) |
| H | 700 | 90 | 250 (T) | 10.5 | 10 | (*5) |
| I | 750 | 90 | 300 (T) | 11 | 10 | (*5) |

(continued)

| Sample | Deposition Temperature (°C) | Orientation Ratio (%) | Film Stress (MPa) (*6) | Piezoelectric Constant $e_{31}$ (C/m$^2$) | DC Stress Lifetime (hr) | Assessment |
|--------|------|------|---------|----|---|------|
| J | 800 | 90 | 350 (T) | 12 | 8 | (*5) |

(*1) Unmeasurable
(*2) Crystal structure does not exhibit perovskite structure
(*3) Not applicable as first temperature or second temperature
(*4) Applicable as first temperature
(*5) Applicable as second temperature
(*6) In the column of "Film Stress", "C" means Compressive and "T" means Tensile

In Sample A, crystal structure of the KNN film did not exhibit a perovskite structure. Therefore, in an X-ray diffraction pattern obtained by carrying out XRD measurement, no peak was observed at least within the 20 range of 20° to 23°. Consequently, a (001) orientation ratio could not be calculated. In addition, since crystal structure of the KNN film failed to form a perovskite structure, the KNN film had a low breakdown voltage characteristic. Thus, a predetermined voltage could not be applied to the KNN film through the top electrode film when measuring the piezoelectric constant $e_{31}$. Therefore, the piezoelectric constant $e_{31}$ could not be measured. Accordingly, the deposition temperature of Sample A is confirmed as not being applicable as either the first temperature or the second temperature.

In each of Samples B to D, the film stress is more than 100 MPa, the piezoelectric constant $e_{31}$ is less than 10 C/m$^2$, and the DC stress lifetime is less than 5 hours. Accordingly, the deposition temperature of Samples B to D are confirmed as not being applicable as either the first temperature or the second temperature.

In each of Samples E and F, the (001) orientation ratio is 95 % or more and the film stress is 100 MPa or less. Accordingly, the deposition temperatures of Samples E and F, that is, a temperature range of 550 °C or more and 600 °C or less, are confirmed as being applicable as the first temperature. On the other hand, in each of Samples E and F, the piezoelectric constant $e_{31}$ is less than 10 C/m$^2$ and the DC stress lifetime is less than 5 hours. Accordingly, the deposition temperatures of Samples E and F are confirmed as not being applicable as the second temperature.

In each of samples G to J, the piezoelectric constant $e_{31}$ is 10 C/m$^2$ or more and the DC stress lifetime is 5 hours or more. Accordingly, the deposition temperatures of Samples G to J, that is, a temperature range of 650 °C or more and 800 °C or less, are confirmed as being applicable as the second temperature. On the other hand, in each of Samples G to J, the (001) orientation ratio is less than 95 % and the film stress is more than 100 MPa. Accordingly, the deposition temperatures of Samples G to J are confirmed as not being applicable as the first temperature.

[Experiment 2]

Experiments were conducted to confirm the effects of depositing the KNN film in two stages while changing temperature.

(Fabrication of Samples 1 to 14)

As a substrate, a Si substrate having a surface of (100) direction, a thickness of 610 μm, a diameter of φ6 inches, and a thermal oxide film (thickness: 200 nm) formed on the surface was prepared. Then, each of Samples 1 to 14 was fabricated as a piezoelectric stack by depositing a ZnO layer (thickness: 25 nm) as a bottom adhesion layer, a Pt film (preferentially oriented in (111) direction with respect to the surface of the substrate, thickness: 200 nm) as a bottom electrode film, a KNN film (thickness: 2 μm) as a piezoelectric film, a RuO$_2$ layer (thickness: 10 nm) as a top adhesion layer, and a Pt film (thickness: 100 nm) as a top electrode film in this order on the thermal oxide film of the Si substrate. The bottom adhesion layer, the bottom electrode film, the KNN film, the top adhesion layer, and the top electrode film were all deposited by RF magnetron sputtering.

In Samples 1 to 11, the KNN films were deposited in two stages while changing temperature conditions. Specifically, firstly, a first KNN film is deposited at a first temperature and then a second KNN film is deposited on the first KNN film at a second temperature different from the first temperature. The first temperature and the second temperature for depositing the KNN films of Samples 1 to 11 are shown in Table 2 below. The deposition time at the first temperature was set to 6 minutes (thickness: 200 nm) and at the second temperature was set to 54 minutes (thickness: 1800 nm). In each of Samples 12 to 14, the KNN film was deposited at a predetermined temperature without changing the temperature conditions. The temperature for depositing the KNN films of Samples 12 to 14 are shown in the column of "Second Temperature" in Table 2 below. The deposition time for depositing the KNN films of Samples 12 to 14 was set to 60 minutes (thickness: 2000 nm). Conditions of depositing the KNN film other than the deposition temperature and the deposition time, and conditions of depositing each film (each layer) other than the KNN film were the same as those in Experiment 1. Samples 1 to 14 were fabricated under conditions the same as the conditions described above, except for the deposition temperature (the first temperature and second temperature) of the KNN films.

<Evaluations>

For each of Samples 1 to 14, a piezoelectric constant $e_{31}$, DC stress withstand capability, film stress, (001) orientation ratio, and AC stress withstand capability of the KNN film were evaluated.

(Evaluations on Piezoelectric Constant, DC Stress Withstand Capability, Film Stress, and (001) Orientation Ratio of KNN Film)

For each of Samples 1 to 14, the piezoelectric constant $e_{31}$, DC stress withstand capability, film stress, and (001) orientation ratio were evaluated using a similar method as the method according to the evaluation of the piezoelectric constant $e_{31}$, DC stress withstand capability, film stress, and (001) orientation ratio of the KNN film in Experiment 1. The evaluation results are shown in Table 2 below.
Similar to Samples A to J, while the bottom adhesion layer and the bottom electrode film are also deposited in each of Samples 1 to 14, the thickness of the bottom adhesion layer and the thickness of the bottom electrode film are sufficiently thinner as compared with the thickness of the KNN film. Therefore, the influence of the bottom adhesion layer and the bottom electrode film was ignored in the calculation of the film stress of the KNN film. In Table 2 also, the term "Compressive" means that the film stress is compressive stress and the term "Tensile" means that the film stress is tensile stress.

(Evaluations on AC stress withstand capability)

AC stress withstand capability was evaluated by measuring the AC stress lifetime. The AC stress lifetime was evaluated in the manner described below. Firstly, strip-shaped pieces each having a length of 20 mm and a width of 2.5 mm were cut out from each of Samples 1 to 14. Then, a simple unimorph cantilever such as that illustrated in FIG. 5(a) was fabricated using a method similar to the method according to the evaluation of the piezoelectric constant $e_{31}$ in Experiment 1. Then, the KNN film (thickness: 2 $\mu$m) of each of the pieces was continuously deformed by continuously applying a negative voltage to (the KNN film through) the top electrode film in such a manner that an unipolar alternating electric field of 300 kV/cm is generated in the KNN film, specifically, by continuously applying an alternating voltage of a unipolar sin wave with an amplitude in the range of 0 V to -60 V to the KNN film through the top electrode film at a frequency of 300 Hz in a state in which the bottom electrode film is grounded. The deformation operation of the KNN film causes the entire cantilever to bend and stretch (vibrate) and a tip of the cantilever to continuously reciprocate in a vertical direction. A displacement amount $\Delta$ of the tip of the cantilever (piezoelectric displacement amount) at this moment was measured by a method similar to the method according to the evaluation of the piezoelectric constant $e_{31}$ in Experiment 1. In the present evaluation, the measurement of the displacement amount $\Delta$ was carried out every time the number of application cycles reached 1 million. The number of application cycles at the time of when the displacement amount $\Delta$ became 80 % or less of the initial displacement value was defined as the AC stress lifetime. Note that, in a case where the displacement amount $\Delta$ was 80 % or more of the initial displacement value even after the number of application cycles reached 50 million, the measurement was stopped, and the measurement result of the AC stress lifetime was determined as more than 50 million times (>50 million times). The measurement results are shown in Table 2 below.

[Table 2]

| Sample | Temperature | | Piezo-electric Constant $e_{31}$ ($C/m^2$) | DC Stress Lifetime (hr) | Film Stress (MPa) (*2) | Direction Ratio (%) | AC Stress Lifetime (*1) |
|---|---|---|---|---|---|---|---|
| | First (°C) | Second (°C) | | | | | |
| 1 | 550 | 400 | 7.0 | 1 | 150 (C) | 90 | >50 million times |
| 2 | 550 | 500 | 8.0 | 2 | 50 (C) | 100 | >50 million times |
| 3 | 550 | 650 | 10.0 | 5 | 50 (C) | 95 | >50 million times |
| 4 | 550 | 700 | 10.5 | 10 | 80 (T) | 92 | >50 million times |
| 5 | 550 | 800 | 12.0 | 10 | 150 (T) | 90 | >50 million times |

(continued)

| Sample | Temperature | | Piezo-electric Constant $e_{31}$ (C/m$^2$) | DC Stress Lifetime (hr) | Film Stress (MPa) (*2) | Direction Ratio (%) | AC Stress Lifetime (*1) |
|---|---|---|---|---|---|---|---|
| | First (°C) | Second (°C) | | | | | |
| 6 | 600 | 500 | 8.0 | 2 | 30 (C) | 95 | >50 million times |
| 7 | 600 | 700 | 10.5 | 5 | 100 (T) | 95 | >50 million times |
| 8 | 600 | 750 | 10.8 | 10 | 150 (T) | 93 | >50 million times |
| 9 | 400 | 700 | 10.0 | 8 | 300 (T) | 70 | 7.5 million times |
| 10 | 500 | 700 | 10.5 | 8 | 300 (T) | 85 | 7.5 million times |
| 11 | 650 | 700 | 10.6 | 7 | 330 (T) | 80 | 7 million times |
| 12 | - | 700 | 10.5 | 5 | 380 (T) | 75 | 5 million times |
| 13 | - | 650 | 10 | 5 | 200 (T) | 90 | 10 million times |
| 14 | - | 500 | 7 | 2 | 200 (C) | 100 | 10 million times |

(*1) The Number of Application Cycles
(*2) In the column of "Film Stress", "C" means Compressive and "T" means Tensile

In each of Samples 3 to 5, 7, and 8, the piezoelectric constant $e_{31}$ is 10 C/m$^2$ or more, the DC stress lifetime is 5 hours or more, and the film stress is 150 MPa or less. It is found from Samples 3 to 5, 7, and 8 that a KNN film including all of the following three features: the piezoelectric constant $e_{31}$ is 10 C/m$^2$ or more (the feature 1); the DC stress lifetime is 5 hours or more (the feature 2); and the film stress is 150 MPa or less (the feature 3), can be obtained in the manner described below. When depositing a KNN film, a first KNN film is firstly deposited at a first temperature at which a (001) orientation ratio becomes 95 % or more and a film stress becomes 100 MPa or less, and then a second KNN film is deposited on the first KNN film at a second temperature at which a piezoelectric constant and DC stress withstand capability become high.

In each of Samples 1, 2, and 6, the piezoelectric constant $e_{31}$ is less than 10 C/m$^2$ and the DC stress lifetime is less than 5 hours. This is considered to be because the second temperature is less than 650 °C (400 °C and 500 °C) in Samples 1, 2, and 6. Accordingly, it is found that a KNN film having a high piezoelectric constant and high DC stress withstand capability, in other words, a KNN film including the features 1 and 2 cannot be obtained when the second temperature is not a temperature at which the piezoelectric constant and DC stress withstand capability of the second KNN film become high.

In Samples 9 to 11, the film stress is more than 150 MPa. This is considered to be because the first temperature is less than 550 °C (400 °C and 500 °C) in Samples 9 and 10 and the first temperature is more than 600 °C (650 °C) in Sample 11. It is found from Samples 9 to 11 that a KNN film having a low film stress cannot be obtained when the first temperature is not a temperature at which the film stress of the first KNN film becomes 100 MPa or less. In Samples 9 to 11, the (001) orientation ratio of the KNN film is less than 90 %. It is found from Samples 9 to 11 that the (001) orientation ratio of the second KNN film cannot be 90 % or more when the first temperature is not a temperature at which the (001) orientation ratio of the first KNN film becomes 95 % or more.

Excellent AC stress withstand capability was exhibited in Samples 1 to 8 in which the number of application cycles until a displacement amount Δ decreases to 80 % or less of an initial displacement value is more than 50 million. This is considered to be because a KNN film having a high (001) orientation ratio and a low film stress (for example, the KNN film having the (001) orientation ratio of 95 % or more and the film stress of 100 MPa or less) is interposed between the bottom electrode film and the second KNN film.

In particular, in Samples 3 to 5, 7, and 8, the piezoelectric constant $e_{31}$ is 10 C/m$^2$ or more, the DC stress lifetime is 5 hours or more, the film stress is 150 MPa or less, and the number of application cycles is more than 10 million (50 million or more). That is, it is found that Samples 3 to 5, 7, and 8 further include a feature of exhibiting excellent AC stress withstand capability (the feature 4) in addition to the features 1 to 3. It is found from Samples 3 to 5, 7, and 8 that a KNN film including all of the features 1 to 4 can be obtained, when depositing a KNN film, by firstly depositing a first KNN film at a first temperature at which a (001) orientation ratio becomes 95 % or more and a film stress becomes 100 MPa or less, and then depositing a second KNN film on the first KNN film at a second temperature that is a predetermined temperature higher than the first temperature.

On the contrary, low AC stress withstand capability was exhibited in Samples 9 to 14 in which the number of application cycles until a displacement amount Δ decreases to 80 % or less of an initial displacement value is 10 million or less. This is considered to be because in Samples 9 to 11, the first KNN film is not deposited at a temperature at which a (001) orientation ratio becomes 95 % or more and a film stress becomes 100 MPa or less, in other words, the first KNN film has a low (001) orientation ratio and high film stress. Further, this is considered to be because in Samples 12 to 14, the KNN film is not composed of a stack of the first KNN film and the second KNN film, specifically, no KNN film having a high (001) orientation ratio and low film stress is interposed between the bottom electrode film and the KNN film.

Note that, in Samples 1 to 11, the KNN film was deposited at the first temperature for 6 minutes, but the deposition time is not limited thereto. The inventors have confirmed that, results similar to the above-mentioned results can be obtained as long as the deposition time at the first temperature is in a range of 1 minute or more and 12 minutes or less. The inventors have been confirmed that, in the deposition of the KNN film, the deposition time at the first temperature, that is, an optimum thickness value of the KNN film deposited at the first temperature may include a certain allowable range.

(Evaluations on Film Stress)

In Experiments 1 and 2, the film stress of the KNN film was calculated from the amount of warpage of the substrate (Si substrate), that is, the radius of curvature of the warpage of the substrate, but the calculation is not limited thereto. As for the film stress of the KNN film, even in a state of a piezoelectric element (piezoelectric device module) in which a MEMS structure is formed by processing a piezoelectric stack, the film stress of the KNN can be known by comparing the MEMS simulation with the current shape.

<Preferred Modes of the Present Disclosure>

Hereinafter, preferred modes of the present disclosure will be additionally described.

(Supplementary description 1)

According to an aspect of the present disclosure, there is provided a piezoelectric stack including:

a substrate;
a bottom electrode film deposited on the substrate; and
a piezoelectric film deposited on the bottom electrode film, the piezoelectric film being constituted by an alkali niobium oxide containing potassium, sodium, niobium and oxygen, wherein
a piezoelectric constant $e_{31}$ of the piezoelectric film is 10 C/m$^2$ or more,
when a negative voltage is applied to a top electrode film provided on the piezoelectric film, at a temperature of 200 °C in such a manner that an electric field of 300 kV/cm is generated between the bottom electrode film and the top electrode film, time from the start of the negative voltage application up to when the density of a leakage current flowing through the piezoelectric film exceeds 30 mA/cm$^2$ is 5 hours or more, and
a film stress of the piezoelectric film is 150 MPa or less.

(Supplementary description 2)

The piezoelectric stack according to the supplementary description 1, wherein preferably, when a negative voltage is continuously applied to the top electrode film in such a manner that a unipolar alternating electric field of 300 kV/cm is generated between the bottom electrode film and the top electrode film, the number of application cycles of the negative voltage until a piezoelectric displacement amount of the piezoelectric film decreases to 80 % or less of an initial piezoelectric displacement value is more than 10 million.

(Supplementary description 3)

The piezoelectric stack according to the supplementary description 1 or 2, wherein preferably, a layer containing zinc and oxygen is provided between the substrate and the bottom electrode film.

(Supplementary description 4)

The piezoelectric stack according to any one of the supplementary descriptions 1 to 3, wherein preferably, the piezoelectric film contains, as a dopant, at least one element selected from copper and manganese at a concentration of 0.1 atomic percent or more and 2.0 atomic percent or less.

(Supplementary description 5)

According to another aspect of the present disclosure, there is provided a method for manufacturing a piezoelectric stack, the method including:

depositing a bottom electrode film on a substrate; and
depositing a piezoelectric film on the bottom electrode film, the piezoelectric film being constituted by an alkali niobium oxide containing potassium, sodium, niobium, and oxygen, wherein
in the deposition of the piezoelectric film, a first piezoelectric film as a part of the piezoelectric film is firstly deposited at a first temperature at which a (001) orientation ratio becomes 95 % or more and a film stress becomes 100 MPa or less, and then a second piezoelectric film as another part of the piezoelectric film is deposited on the first piezoelectric film at a second temperature at which a piezoelectric constant $e_{31}$ of the second piezoelectric film becomes 10 C/m$^2$ or more and at which when a negative voltage is applied to a top electrode film deposited on the second piezoelectric film in such a manner that an electric field of 300 kV/cm is generated between the bottom electrode film and the top electrode film, time up to when the density of a leakage current flowing through the second piezoelectric film exceeds 30 mA/cm$^2$ becomes 5 hours or more.

(Supplementary description 6)

The method according to the supplementary description 5, wherein preferably,
the thickness of the first piezoelectric film is 20 % or less of the total thickness of the piezoelectric film.

(Supplementary description 7)

The method according to the supplementary description 5 or 6, wherein preferably,
the first temperature is a temperature at which a (001) orientation ratio of the first piezoelectric film becomes 95 % or more when the first piezoelectric film of a thickness of 2 $\mu$m is deposited at the first temperature.

(Supplementary description 8)

The method according to any one of the supplementary descriptions 5 to 7, wherein preferably,
the first temperature is a temperature at which a film stress of the first piezoelectric film becomes 100 MPa or less when the first piezoelectric film of a thickness of 2 $\mu$m is deposited at the first temperature.

(Supplementary description 9)

The method according to any one of the supplementary descriptions 5 to 8, preferably, the method further including providing a layer containing zinc and oxygen on the substrate before the depositing of the piezoelectric film, wherein
in the deposition of the bottom electrode film, the bottom electrode film is deposited on the layer containing zinc and oxygen.

(Supplementary description 10)

According to yet another aspect of the present disclosure, there is provided a piezoelectric element or a piezoelectric device module, including:

a substrate;
a bottom electrode film deposited on the substrate;
a piezoelectric film deposited on the bottom electrode film, the piezoelectric film being constituted by an alkali niobium oxide containing potassium, sodium, niobium and oxygen; and
a top electrode film deposited on the piezoelectric film, wherein
a piezoelectric constant $e_{31}$ of the piezoelectric film is 10 C/m$^2$ or more, and
when a negative voltage is applied to the top electrode film at a temperature of 200 °C in such a manner that an electric field of 300 kV/cm is generated between the bottom electrode film and the top electrode film, time from the start of the negative voltage application up to when the density of a leakage current flowing through the piezoelectric film exceeds 30 mA/cm$^2$ is 5 hours or more.

(Supplementary description 11)

According to yet another aspect of the present disclosure, there is provided a piezoelectric film constituted by an alkali niobium oxide containing potassium, sodium, niobium and oxygen, wherein

a piezoelectric constant $e_{31}$ of the piezoelectric film is 10 C/m$^2$ or more,
when a negative voltage is applied to a top electrode film provided on the piezoelectric film, at a temperature of 200 °C in such a manner that an electric field of 300 kV/cm is generated in the piezoelectric film, time from the start of the negative voltage application up to when the density of a leakage current flowing through the piezoelectric film exceeds 30 mA/cm$^2$ is 5 hours or more, and
a film stress of the piezoelectric film is 150 MPa or less.

(Supplementary description 12)

The piezoelectric film, piezoelectric element, or piezoelectric device module according to the supplementary description 10 or 11, wherein preferably,
when an alternating negative voltage is continuously applied to the top electrode film (top electrode film to be provided on the piezoelectric film) in such a manner that a unipolar alternating electric field of 300 kV/cm is generated between the bottom electrode film and the top electrode film (in the piezoelectric film), the number of application cycles of the alternating negative voltage until a piezoelectric displacement amount of the piezoelectric film decreases to 80 % or less of an initial piezoelectric displacement value is more than 10 million.

[Reference Signs List]

1      Substrate
2      Bottom electrode film
3      Piezoelectric film
4      Top electrode film
6      (Bottom) adhesion layer
7      (Top) adhesion layer
10    Piezoelectric stack
20    Piezoelectric element
30    Piezoelectric device module

**Claims**

1.  A piezoelectric stack comprising:

    a substrate;
    a bottom electrode film deposited on the substrate; and
    a piezoelectric film deposited on the bottom electrode film, the piezoelectric film being constituted by an alkali niobium oxide containing potassium, sodium, niobium and oxygen, wherein
    a piezoelectric constant $e_{31}$ of the piezoelectric film is 10 C/m$^2$ or more,
    when a negative voltage is applied to a top electrode film provided on the piezoelectric film, at a temperature of 200 °C in such a manner that an electric field of 300 kV/cm is generated between the bottom electrode film and the top electrode film, time from the start of the negative voltage application up to when the density of a leakage current flowing through the piezoelectric film exceeds 30 mA/cm$^2$ is 5 hours or more, and
    a film stress of the piezoelectric film is 150 MPa or less.

2.  The piezoelectric stack according to claim 1, wherein when an alternating negative voltage is continuously applied to the top electrode film in such a manner that a unipolar alternating electric field of 300 kV/cm is generated between the bottom electrode film and the top electrode film, the number of application cycles of the alternating negative voltage until a piezoelectric displacement amount of the piezoelectric film decreases to 80 % or less of an initial piezoelectric displacement value is more than 10 million.

3.  The piezoelectric stack according to claim 1 or 2, wherein the piezoelectric film contains, as a dopant, at least one element selected from copper and manganese at a concentration of 0.1 atomic percent or more and 2.0 atomic percent or less.

4. A method for manufacturing a piezoelectric stack, the method comprising:

   depositing a bottom electrode film on a substrate; and
   depositing a piezoelectric film on the bottom electrode film, the piezoelectric film being constituted by an alkali niobium oxide containing potassium, sodium, niobium, and oxygen, wherein
   in the deposition of the piezoelectric film, a first piezoelectric film as a part of the piezoelectric film is firstly deposited at a first temperature at which a (001) orientation ratio becomes 95 % or more and a film stress becomes 100 MPa or less, and then a second piezoelectric film as another part of the piezoelectric film is deposited on the first piezoelectric film at a second temperature at which a piezoelectric constant $e_{31}$ of the second piezoelectric film becomes 10 C/m$^2$ or more and at which when a negative voltage is applied to a top electrode film deposited on the second piezoelectric film in such a manner that an electric field of 300 kV/cm is generated between the bottom electrode film and the top electrode film, time up to when the density of a leakage current flowing through the second piezoelectric film exceeds 30 mA/cm$^2$ becomes 5 hours or more.

5. A piezoelectric element comprising:

   a substrate;
   a bottom electrode film deposited on the substrate;
   a piezoelectric film deposited on the bottom electrode film, the piezoelectric film being constituted by an alkali niobium oxide containing potassium, sodium, niobium and oxygen; and
   a top electrode film deposited on the piezoelectric film, wherein
   a piezoelectric constant $e_{31}$ of the piezoelectric film is 10 C/m$^2$ or more,
   when a negative voltage is applied to the top electrode film at a temperature of 200 °C in such a manner that an electric field of 300 kV/cm is generated between the bottom electrode film and the top electrode film, time from the start of the negative voltage application up to when the density of a leakage current flowing through the piezoelectric film exceeds 30 mA/cm$^2$ is 5 hours or more, and
   a film stress of the piezoelectric film is 150 MPa or less.

6. The piezoelectric element according to claim 5, wherein when a negative voltage is continuously applied to the top electrode film in such a manner that a unipolar alternating electric field of 300 kV/cm is generated between the bottom electrode film and the top electrode film, the number of application cycles of the negative voltage until a piezoelectric displacement amount of the piezoelectric film decreases to 80 % or less of an initial piezoelectric displacement value is more than 10 million.

**FIG. 1**

**FIG. 2**

**FIG. 3**

**FIG. 4**

# FIG. 5

(a)

(b)

**EP 4 694 657 A1**

## INTERNATIONAL SEARCH REPORT

| International application No. |
|---|
| **PCT/JP2023/045474** |

| A. | CLASSIFICATION OF SUBJECT MATTER |
|---|---|

*H10N 30/853*(2023.01)i; *H10N 30/01*(2023.01)i; *H10N 30/06*(2023.01)i; *H10N 30/20*(2023.01)i; *H10N 30/30*(2023.01)i; *H10N 30/076*(2023.01)i; *H10N 30/079*(2023.01)i; *H10N 30/082*(2023.01)i; *H10N 30/87*(2023.01)i
FI:   H10N30/853; H10N30/01; H10N30/076; H10N30/079; H10N30/20; H10N30/082; H10N30/06; H10N30/87; H10N30/30

According to International Patent Classification (IPC) or to both national classification and IPC

| B. | FIELDS SEARCHED |
|---|---|

Minimum documentation searched (classification system followed by classification symbols)

H10N30/853; H10N30/01; H10N30/06; H10N30/20; H10N30/30; H10N30/076; H10N30/079; H10N30/082; H10N30/87

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2021-12909 A (SUMITOMO CHEMICAL COMPANY, LIMITED) 04 February 2021 (2021-02-04) paragraphs [0004], [0009]-[0012], [0043], fig. 1 | 1, 3, 5 |
| A | | 2, 4, 6 |
| Y | JP 2022-165896 A (SUMITOMO CHEMICAL COMPANY, LIMITED) 01 November 2022 (2022-11-01) paragraphs [0006], [0016], [0019], [0032], fig. 1 | 1, 3, 5 |
| A | | 2, 4, 6 |
| Y | JP 2015-529963 A (TDK CORPORATION) 08 October 2015 (2015-10-08) paragraphs [0006], [0012], [0024], [0031], [0036], fig. 1, 3-4 | 1, 3, 5 |
| A | | 2, 4, 6 |

☑ Further documents are listed in the continuation of Box C.          ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **20 February 2024** | **05 March 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT

| | International application No. |
|---|---|
| | **PCT/JP2023/045474** |

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | JP 2017-76730 A (SCIOCS CO., LTD., SUMITOMO CHEMICAL COMPANY, LIMITED) 20 April 2017 (2017-04-20) paragraphs [0012], [0015], [0018], [0021], [0036], fig. 1 | 3 |
| A | | 1-2, 4-6 |

Form PCT/ISA/210 (second sheet) (July 2022)

## INTERNATIONAL SEARCH REPORT
### Information on patent family members

International application No.

**PCT/JP2023/045474**

| Patent document cited in search report | | | Publication date (day/month/year) | Patent family member(s) | | | Publication date (day/month/year) |
|---|---|---|---|---|---|---|---|
| JP | 2021-12909 | A | 04 February 2021 | US | 2021/0005805 | A1 | |
| | | | | paragraphs [0005], [0019]-[0022], [0069], fig. 1 | | | |
| | | | | EP | 3761383 | A1 | |
| JP | 2022-165896 | A | 01 November 2022 | JP | 2022-165884 | A | |
| | | | | JP | 2022-165643 | A | |
| | | | | JP | 6996019 | B1 | |
| | | | | WO | 2022/224594 | A1 | |
| JP | 2015-529963 | A | 08 October 2015 | US | 8994251 | B2 | |
| | | | | column 1, line 60 to column 2, line 4, column 2, lines 53-57, column 4, lines 18-26, column 5, lines 41-51, column 6, lines 19-29, fig. 1, 3, 4 | | | |
| | | | | WO | 2014/021410 | A1 | |
| | | | | CN | 104395087 | A | |
| JP | 2017-76730 | A | 20 April 2017 | US | 2018/0301618 | A1 | |
| | | | | paragraphs [0007], [0043], [0046], [0049], [0064], fig. 1 | | | |
| | | | | US | 2021/0359195 | A1 | |
| | | | | WO | 2017/065133 | A1 | |
| | | | | EP | 3364471 | A1 | |
| | | | | EP | 3922749 | A1 | |

Form PCT/ISA/210 (patent family annex) (July 2022)

**EP 4 694 657 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009295786 A
- JP 2017076730 A
- JP 2018207055 A